# EUROPÄISCHE PATENTSCHRIFT

(11) **EP 1 198 880 B1**
(45) Veröffentlichungstag und Bekanntmachung des Hinweises auf die Patenterteilung: **30.09.2009**
(21) Anmeldenummer: 00954297.8
(22) Anmeldetag: 30.06.2000
(51) Int. Cl.: H03F 3/72, H03F 1/52

(54) **ANORDNUNG MIT EINEM ERSTEN VERSTÄRKER UND EINEM ZWEITEN VERSTÄRKER, VON WELCHEN JEWEILS NUR MAXIMAL EINER VERSTÄRKEN SOLL**
ARRANGEMENT COMPRISING A FIRST AND A SECOND AMPLIFIER WHEREBY A MAXIMUM OF ONE OF SAID AMPLIFIERS AMPLIFIES
ENSEMBLE COMPRENANT UN PREMIER AMPLIFICATEUR ET UN DEUXIEME AMPLIFICATEUR, DANS LEQUEL SEULEMENT UN AU MAXIMUM DE CES DERNIERS DOIT A CHAQUE FOIS ETRE OPERATIONNEL

(30) Priorität: 30.06.1999 DE 19930118
(43) Veröffentlichungstag der Anmeldung: 24.04.2002
(73) Patentinhaber: Infineon Technologies AG, 85579 Neubiberg (DE)
(72) Erfinder: MUSIOL, Lothar, Tempe, AZ 85284 (US); HOHMANN, Henning, D-81243 München (DE)
(74) Vertreter: Viering, Jentschura & Partner
(86) Internationale Anmeldenummer: PCT/DE2000/002130
(87) Internationale Veröffentlichungsnummer: WO 2001/003291

(56) Entgegenhaltungen:
- EP-A1- 0 648 010
- US-A- 3 345 578
- US-A- 3 519 945
- US-A- 4 417 240
- US-A- 5 541 554

## Beschreibung

Die vorliegende Erfindung betrifft eine Vorrichtung mit zwei Verstärkern, von denen jeweils nur einen verstärken soll.

Bei existierenden Anordnungen dieser Art erfolgt das Umschalten vom ersten Verstärker auf den zweiten Verstärker oder umgekehrt unter Verwendung einer mehr oder weniger komplizierten Umschalteinrichtung. Eine solche Umschalteinrichtung weist mitunter einen relativ komplizierten Aufbau auf und erfordert zudem mindestens einen zusätzlichen (Steuer-)Anschluß, was insbesondere bei integrierten Schaltungen oder Unterbringung der Anordnung in ein Miniaturgehäuse nachteilig sein kann; insbesondere die benötigte Chipfläche und die HF-Eigenschaften können dadurch negativ beeinflußt werden.

In der GB-A-2 289 810 ist eine Schalteinrichtung für HF-Signale gezeigt, bei der bipolare Verstärkertransistoren kollektorseitig an einen einzigen Ausgang gekoppelt sind und basisseitig von je einem HF-Signal angesteuert werden. Zur Umschaltung zwischen den Transistoren ist eine Steuerungseinrichtung vorgesehen, die in Abhängigkeit von einem ihr eingangsseitig zugeführten Steuersignal ausgangsseitig jeweilige den Verstärkertransistoren zugeordnete Schaltsignale erzeugt, die an deren Basisanschlüssen eingekoppelt werden.

In der EP-A-0 648 010 ist ein Differenzverstärker gezeigt mit zwei emittergekoppelten Verstärkertransistoren, die über eine Stromquelle mit einem Versorgungspotentialanschluß verbunden sind. Zwei weitere emittergekoppelte und über eine separate Stromquelle an den Versorgungspotentialanschluß geschaltete Transistoren sind einerseits basisseitig an die Basisanschlüsse der erstgenannten Transistoren und andererseits kollektorseitig kreuzgekoppelt an die Basisanschlüsse der erstgenannten Transistoren angeschlossen.

In der US-A-4 417 240 sind Maßnahmen gezeigt, um an Eingangsanschlüsse von Verstärkertransistoren anzulegende Vorspannungen zu erzeugen.

In der US-A-3 345 578 ist eine Verstärkerschaltung gezeigt, die zwei mit je einem Eingangssignal ansteuerbare Verstärker zeigt, die ausgangsseitig an eine gemeinsame Last angeschlossen sind. Eine Bias-Verstärkerschaltung ist zwischen die vorgenannten Verstärkerschaltungen geschaltet, um dazwischen eine Umschaltung zu bewirken. Der Emitter-Anschluß eines Verstärkers ist über die Bias-Verstärkerschaltung an die Basis- und die Emitter-Elektrode des anderen Verstärkers angeschlossen.

Der vorliegenden Erfindung liegt die Aufgabe zugrunde, die Anordnung der eingangs genannten Art derart weiterzubilden, daß das Umschalten zwischen den Verstärkern mit minimalem Zusatzaufwand und störungsfrei erfolgen kann.

Diese Aufgabe wird erfindungsgemäß durch eine Vorrichtung gemäß den Merkmalen des Patentanspruchs 1 gelöst.

Es ist vorgesehen, daß der zweite Verstärker abhängig von den sich am Eingangsanschluß des ersten Verstärkers einstellenden Verhältnissen betrieben wird, indem ein an den Signaleingang eines der Verstärker angeschlossenes Schaltelement in Abhängigkeit von einem am Signaleingang des anderen Verstärkers anliegenden Signal schaltbar ist.

Berücksichtigt man als die Verhältnisse, in Abhängigkeit von welchen der zweite Verstärker betrieben wird, nur solche Verhältnisse, die keine Wechselwirkungen mit den durch den ersten Verstärker zu verstärkenden Signalen zeigen, also beispielsweise die sich am Eingangsanschluß des ersten Verstärkers einstellende Gleichspannung, wenn das zu verstärkende Signal ein HF-Signal ist, so kann die Umschaltung zwischen den Verstärkern über den Eingangsanschluß des ersten Verstärkers gesteuert werden. Eine solche Umschaltung läßt sich denkbar einfach realisieren und kann gerade wegen dieser Einfachheit problemlos ohne oder jedenfalls ohne nennenswerten Auswirkungen auf Funktion und Wirkungsweise der Verstärker erfolgen.

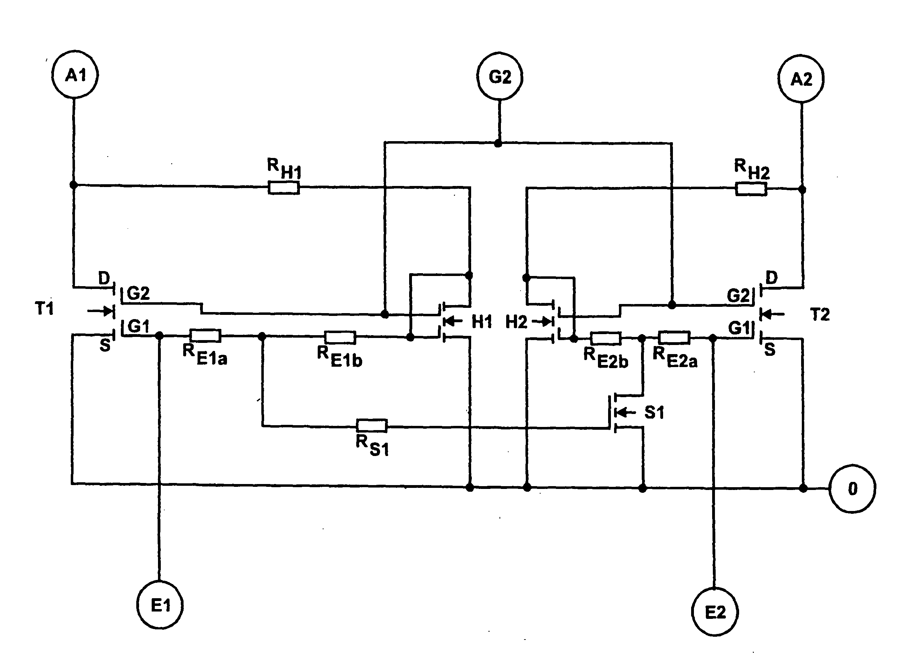

Vorteilhafte Weiterbildungen der Erfindung sind den Unteransprüchen, der folgenden Beschreibung und der Figur entnehmbar.

Die Erfindung wird nachfolgend anhand eines Ausführungsbeispiels unter Bezugnahme auf die Figur näher erläutert.

Die Figur zeigt die nachfolgend näher beschriebene Anordnung.

Die nachfolgend beschriebene Anordnung ist Bestandteil einer integrierten Schaltung. Obgleich die Vorteile, die sich durch die beschriebene Anordnung erzielen lassen, in diesem Fall besonders groß sind, besteht hierauf keine Einschränkung.

Die betrachtete Anordnung enthält zwei Verstärker, von welchen jeweils nur immer einer verstärken soll.

Die Verstärker werden im betrachteten Beispiel durch einen ersten Transistor T1 und einen zweiten Transistor T2 gebildet. Die Transistoren sind im betrachteten Beispiel MOSFETS in Dual-Gate-Ausführung.

Es sei bereits an dieser Stelle darauf hingewiesen, daß die Verstärker auch durch beliebige andere Transistoren oder sonstige Elemente oder mehrere Transistoren oder Elemente umfassende Einrichtungen gebildet werden können.

Die Transistoren T1 und T2 weisen jeweils einen Source-Anschluß S, einen Drain-Anschluß D, einen ersten Gate-Anschluß G1, und einen zweiten Gate-Anschluß G2 auf, wobei die ersten Gate-Anschlüsse G1 jeweils zur Eingabe der zu verstärkenden Signale dienen, und wobei die zweiten Gate-Anschlüsse G2 zur Regelung der Verstärkung dienen.

Die gezeigte Anordnung weist externe Ein- und/oder Ausgabeanschlüsse A1, A2, E1, E2, und 0 auf. Von diesen Anschlüssen dienen
- der Anschluß E1 zur Eingabe des durch den ersten Transistor T1 zu verstärkenden Signals und zur Steuerung der Umschaltung zwischen den Transistoren T1 und T2,
- der Anschluß E2 zur Eingabe des durch den zweiten Transistor T2 zu verstärkenden Signals,
- der Anschluß A1 zur Eingabe einer unter anderem an den Drainanschluß des ersten Transistors T1 angelegten Versorgungsspannung und zur Ausgabe des durch den ersten Transistor T1 verstärkten Signals,
- der Anschluß A2 zur Eingabe einer unter anderem an den Drainanschluß des zweiten Transistors T2 angelegten Versorgungsspannung und zur Ausgabe des durch den zweiten Transistor T2 verstärkten Signals,
- der Anschluß G2 zur Eingabe einer an die zweiten Gateanschlüsse G2 der Transistoren T1 und T2 angelegten, zur Verstärkungseinstellung dienen Steuerspannung, und
- der Anschluß 0 zur Eingabe des unter anderem an die Sourceanschlüsse S der Transistoren T1 und T2 angelegten Massepotentials.

Die restlichen Bestandteile der in der Figur gezeigten Anordnung, d.h. Transistoren H1, H2 und S1 und Widerstände R_{H1}, R_{H2}, R_{E1a}, R_{E1b}, R_{E2a}, und R_{E2b} dienen unter anderem (aber nicht ausschließlich) dazu, die Transistoren T1 und T2
- durch eine geeignete Arbeitspunkteinstellung in einen Zustand zu versetzen, in welchem an den ersten Gateanschluß G1 der betreffenden Transistoren angelegte Signale verstärkt werden (können), oder
- durch eine geeignete Arbeitspunktverstellung in einen Zustand zu versetzen, in welchem an den ersten Gateanschluß G1 der betreffenden Transistoren angelegte Signale nicht verstärkt werden (können).

Die Arbeitspunkteinstellung bzw, die Arbeitspunktverstellung wird im betrachteten Beispiel dadurch realisiert, daß die ersten Gateanschlüsse G1 der Transistoren T1 und T2 mit Gleichspannungen beaufschlagt werden, deren Höhe variierbar ist.

Daß insbesondere dann, wenn die zu verstärkenden Signale analoge Wechselspannungen sind, durch Anlegen einer Gleichspannung an den Gateanschluß des betreffenden Transistors dessen Arbeitspunkt einstellbar oder veränderbar ist, ist bekannt und bedarf keiner näheren Erläuterung.

Die durch die Transistoren T1 und T2 zu verstärkenden Signale sind im betrachteten Beispiel Hochfrequenz-Signale. Es sei jedoch bereits an dieser Stelle darauf hingewiesen, daß dies nicht unbedingt der Fall sein muß.

Die zu verstärkenden Signale werden, wie vorstehend bereits erwähnt wurde, über die Anschlüsse E1 bzw. E2 eingegeben. Sie werden über den Anschlüssen E1 und E2 vorgeschaltete (in der Figur nicht gezeigte) Kondensatoren geleitet, um einen gegebenenfalls vorhandenen Gleichstromanteil zu entfernen.

Die zu verstärkenden Signale, die über den Anschluß E1 eingegeben werden, werden dem ersten Gateanschluß G1 des ersten Transistors T1 zugeführt. Damit diese Signale durch den Transistor T1 optimal verstärkt werden, muß dieser durch Anlegen einer vorbestimmten Gleichspannung an ersten Gateanschluß G1 auf einen geeigneten Arbeitspunkt eingestellt sein. Die Gleichspannung, die hierzu benötigt wird (beispielsweise 1,5 V), wird im betrachteten Beispiel unter Verwendung der Widerstände R_{H1}, R_{E1a}, und R_{E1b} und des Transistors H1 aus der am Drainanschluß D des ersten Transistors T1 angelegten Versorgungsspannung intern innerhalb der betreffenden Anordnung erzeugt und dem ersten Gateanschluß G1 des Transistors T1 zugeführt.

Wenn die am Gateanschluß G1 des ersten Transistors T1 anliegende Gleichspannung vom idealen Wert (beispielsweise den genannten 1,5 V) abweicht, verstärkt der Transistor T1 das ihm zugeführte HF-Signal zunächst "nur" nicht mehr optimal, und schließlich (beispielsweise bei Gleichspannungen unter 0,5 V) überhaupt nicht mehr.

Die zu verstärkenden Signale, die über den Anschluß E2 eingegeben werden, werden dem ersten Gateanschluß G1 des zweiten Transistors T2 zugeführt. Damit diese Signale durch den Transistor T2 optimal verstärkt werden, muß auch dieser durch Anlegen einer vorbestimmten Gleichspannung am ersten Gateanschluß G1 auf einen geeigneten Arbeitspunkt eingestellt sein. Die Gleichspannung, die hierzu benötigt wird (beispielsweise 1,5 V), wird im betrachteten Beispiel unter Verwendung der Widerstände R_{H2}, R_{E2a}, und R_{E2b} und des Transistors H2 aus der am Drainanschluß D des ersten Transistors T2 angelegten Versorgungsspannung intern innerhalb der betreffenden Anordnung erzeugt und dem ersten Gateanschluß G1 des Transistors T2 zugeführt.

Wenn die am Gateanschluß G1 des zweiten Transistors T2 anliegende Gleichspannung vom idealen Wert (beispielsweise den genannten 1,5 V) abweicht, verstärkt der Transistor T2 das ihm zugeführte HF-Signal zunächst "nur" nicht mehr optimal, und schließlich (beispielsweise bei Gleichspannungen unter 0,5 V) überhaupt nicht mehr.

In der betrachteten Anordnung wird insbesondere durch den Transistor S1 dafür gesorgt, daß nur entweder der Transistor T1 oder der Transistor T2 die ihnen zugeführten Signale verstärken. Dies wird dadurch erreicht,
- daß dann, wenn am ersten Gateanschluß G1 des ersten Transistors T1 eine Gleichspannung anliegt, die den ersten Transistor T1 in die Lage versetzt, über den Anschluß E1 eingegebene Signale zu verstärken, die am ersten Gateanschluß G1 des zweiten Transistors T2 anliegende Gleichspannung auf einen Wert gebracht wird, durch den bewirkt wird, daß er die über den Anschluß E2 eingegebenen Signale nicht verstärken kann, bzw.
- daß dann, wenn die am ersten Gateanschluß G1 des ersten Transistors T1 anliegende Gleichspannung auf einen Wert gebracht wird, durch den bewirkt wird, daß er die über den Anschluß E1 eingegebenen Signale nicht verstärken kann, die am ersten Gateanschluß G1 des zweiten Transistors T2 anliegende Gleichspannung auf dem Wert belassen wird, der den zweiten Transistor T2 in die Lage versetzt, über den Anschluß E2 eingegebene Signale zu verstärken.

Der Transistor S1 ist ein Schaltelement mit einer gesteuerten Strecke und einem Steueranschluß. Die gesteuerte Strecke ist dessen Drain-Source-Pfad, der Steueranschluß, der den Schaltzustand der gesteuerten Strecke steuert, ist der Gateanschluß des Transistors S1. Der Gateanschluß G des Transistors S1, über welchen die vorgenannte Funktionsweise bewerkstelligt wird, ist über die Widerstände R_{E1a} und R_{S1} mit dem ersten Gateanschluß G1 des ersten Transistors T1 verbunden. Dadurch liegt die am ersten Gateanschluß G1 des ersten Transistors T1 anliegende Gleichspannung auch am Gateanschluß des Transistors S1 an. Dies gilt nicht für die über den Anschluß E1 eingegebenen HF-Signale; diese können die Widerstände R_{E1a} und R_{S1} nicht passieren. Der Drainanschluß des Transistors S1 ist über den Widerstand R_{E2a} an den Gateanschluß G1 des Verstärkertransistors T2 angeschlossen. Der Sourceanschluß des Transistors S1 ist an den Masse- oder Bezugspotentialanschluß 0 angeschlossen. Der Steueranschluß, über den der Schaltzustand der Drain-Source-Strecke des Transistors S1 steuerbar ist, ist über den Widerstand R_{S1} sowie über den weiteren Widerstand R_{E1a} an den Gateanschluß G1 des Verstärkertransistors T1 angeschlossen.

Der Transistor S1 ist nun so beschaffen,
- daß er durch die Gleichspannung, die sich am ersten Gateanschluß G1 des Transistors T1 einstellen muß, um die über den Anschluß E1 eingegebenen Signale zu verstärken, in den leitenden Zustand versetzt wird, und
- daß er durch die Gleichspannung, bei welcher der Transistor die über den Anschluß E1 eingegebenen Signale nicht mehr verstärkt, in den sperrenden Zustand versetzt wird.

Wenn und so lange der Transistor S1 leitet, wird der erste Gateanschluß G1 des zweiten Transistors T2 über den Widerstand R_{E2a} und den Transistor S1 mit dem Masseanschluß 0 verbunden. Dadurch sinkt die sich am ersten Gateanschluß des zweiten Transistors T2 einstellende Gleichspannung auf einen Wert ab, der zur Folge hat, daß über den Anschluß E2 eingegebene Signale durch den Transistor T2 nicht verstärkt werden (nicht verstärkt werden können).

Wenn und so lange der Transistor S1 sperrt, behält die aus der über den Anschluß A2 eingegebenen Versorgungsspannung erzeugte Gleichspannung am ersten Gateanschluß G1 des zweiten Transistors T2 ihren Wert unverändert bei, wodurch der Transistor T2 in der Lage ist, über den Anschluß E2 eingegebene Signale zu verstärken.

Um die am ersten Gateanschluß G1 des ersten Transistors T1 anliegende Gleichspannung auf einen Wert zu bringen, der zur Folge hat, daß der erste Transistor T1 über den Anschluß E1 eingegebene Signale nicht mehr verstärkt (aufgrund der damit verbundenen Arbeitspunktverstellung nicht mehr verstärken kann), wird der Anschluß E1 über einen Schalter oder auf beliebige andere Art und Weise gleichstrommäßig auf Massepotential gezogen. Dadurch sinkt die sich am ersten Gateanschluß G1 des ersten Transistors T1 einstellende Gleichspannung auf einen Wert ab, der zur Folge hat, daß über den Anschluß E1 eingegebene Signale durch den Transistor T1 nicht verstärkt werden (nicht verstärkt werden können), und daß der Transistor T1 sperrt.

Auf die beschriebene Art und Weise kann ohne Vorsehen eines eigenen Umschalt-Anschlusses erreicht werden, daß sich von den Transistoren T1 und T2 stets nur einer in einem Zustand befindet, in welchem er angelegte Signale verstärkt.

Durch den möglichen Verzicht auf einen eigenen Umschalt-Anschluß läßt sich die Anordnung mit minimalem Aufwand realisieren. Dabei werden die Verstärker in keinster Weise gestört

Der Vollständigkeit halber sei angemerkt, daß die Doppelfunktion der Anschlüsse A1 und A2 (Zuführung der Versorgungsspannung und Ausgabe der verstärkten Signale) keine Probleme bereitet. Die Versorgungsspannungen sind Gleichspannungen, die den Anschlüssen A1 und A2 über diesen vorgeschaltete (in der Figur nicht gezeigte) Spulen zugeführt werden. Die verstärkten Signale sind hingegen HF-Signale, die zwischen den Anschlüssen A1 und A2 und den diesen vorgeschalteten Spulen abgegriffen und (vorzugsweise über einen Kondensator) ausgekoppelt werden. Die Versorgungsspannungen und die verstärkten Signale beeinflussen einander nicht und sind problemlos voneinander trennbar.

Es sei ferner darauf hingewiesen, daß die beschriebene Anordnung zweifellos nicht die einzige Möglichkeit zur Realisierung des der beschriebenen Umschaltung zugrundeliegenden Prinzips darstellt. Dies dürfte einleuchten und bedarf keiner Belegung durch Beispiele.

Zu der vorliegend betrachteten Anordnung ist anzumerken,
- daß die an den ersten Gateanschlüssen der Transistoren T1 und T2 anliegenden Gleichspannungen auch von Haus aus Werte haben können, bei welchen die Transistoren T1 und T2 nicht in der Lage sind, die zu verstärkenden Signale zu verstärken, und/oder daß die Gleichspannungen, die an die ersten Gateanschlüsse der Transistoren T1 und T2 angelegt werden müssen, um sie in die Lage zu versetzen, die zu verstärkenden Signale zu verstärken, auch über den Anschluß E1 eingegeben bzw. durch den Transistor S1 oder in sonstiger Weise erzeugt und/oder auf den betreffenden Gateanschluß durchgeschaltet werden können,
- daß nicht zwangsläufig die Höhe der sich am ersten Gateanschluß des ersten Transistors einstellenden Gleichspannung für den Betrieb des zweiten Transistors ausschlaggebend sein muß, sondern zusätzlich oder alternativ auch andere Verhältnisse (beispielsweise der zeitliche Verlauf und/oder die Frequenz der am ersten Gateanschluß des ersten Transistors T1 anliegenden Spannung) berücksichtigt werden können,
- daß anstatt der Widerstände R_{H1} und R_{H2} und der Transistoren H1 und H2 auch andere Arten der Stromeinprägung zum Einsatz kommen können (an den den Widerständen R_{H1} und R_{H2} nachgeschalteten Transistoren H1 und H2 erfolgt eine Stromspiegelung), und
- daß die Widerstände R_{E1a}, R_{E2a} und R_{S1} auch den Wert 0 Ω annehmen können, wenn R_{E1a} << (R_{E1b} + R_{H1}) erfüllt ist.

Unabhängig davon kann auch vorgesehen werden, die Veränderung der Gleichspannungen an den Gateanschlüssen der Transistoren T1 und T2 zusätzlich oder alternativ abhängig von über andere der vorhandenen Anschlüsse eingegebenen Spannungen oder Signalen (beispielsweise abhängig von einer über den Anschluß G2 eingegebenen Spannung) und/oder abhängig von internen Signalen und/oder abhängig von logischen Verknüpfungen von internen und/oder externen Signalen erfolgen zu lassen.

Die beschriebene Anordnung ermöglicht es unabhängig von den Einzelheiten der praktischen Realisierung, daß das Umschalten zwischen den (vorliegend durch die Transistoren T1 und T2 gebildeten) Verstärkern mit minimalem Aufwand und ohne Störung der Verstärker erfolgen kann.

## Patentansprüche

1. Anordnung mit einem ersten Verstärker (T1), der einen Anschluß für ein zu verstärkendes Signal (G1, E1) und eine gesteuerte Strecke (D, S) aufweist, mit einem zweiten Verstärker (T2), der einen Anschluß für ein zu verstärkendes Signal (G1, E2) und eine gesteuerte Strecke (D, S) aufweist, wobei die gesteuerten Strecken an einen Anschluß (0) für ein Massepotential angeschlossen sind,
**gekennzeichnet durch**
einen Schalttransistor (S1), dessen Drain-Source-Strecke einerseits an ihrem Drain-Anschluß an einen der Anschlüsse für das zu verstärkende Signal (G1, E2) eines der Verstärker (T2) angeschlossen ist und andererseits an ihrem Source-Anschluß an den Anschluß (0) für das Massepotential, wobei ein die Drain-Source-Strecke des Schalttransistors (S1) steuernder Gate-Anschluß an den Anschluß für das zu verstärkendes Signal (G1, E1) des anderen Verstärkers (T1) angeschlossen ist.

2. Anordnung nach Anspruch 1,
**dadurch gekennzeichnet,**
**daß** die Verhältnisse, abhängig von welchen der zweite Verstärker (T2) betrieben wird, die Höhe oder der Verlauf der sich am Eingangsanschluß (G1) des ersten Verstärkers (T1) einstellenden Spannung sind.

3. Anordnung nach Anspruch 1 oder 2,
**dadurch gekennzeichnet,**
**daß** die durch die Verstärker (T1, T2) zu verstärkenden Signale analoge Wechselspannungen sind, und daß die Verhältnisse, abhängig von welchen der zweite Verstärker (T2) betrieben wird, die Höhe der sich am Eingangsanschluß (G1) des ersten Verstärkers (T1) einstellenden Gleichspannung ist.

4. Anordnung nach Anspruch 3,
**dadurch gekennzeichnet,**
**daß** abhängig von der sich am Eingangsanschluß (G1) des ersten Verstärkers (T1) einstellenden Gleichspannung die sich am Eingangsanschluß (G1) des zweiten Verstärkers (T2) einstellende Gleichspannung variiert wird.

5. Anordnung nach einem der vorhergehenden Ansprüche,
**dadurch gekennzeichnet,**
**daß** innerhalb der Anordnung Gleichspannungen erzeugt und an die Eingangsanschlüsse (G1) der Verstärker (T1, T2) angelegt werden.

6. Anordnung nach Anspruch 5,
**dadurch gekennzeichnet,**
**daß** die intern erzeugten und an die Eingangsanschlüsse (G1) der Verstärker (T1, T2) angelegten Gleichspannungen einen Wert haben, durch die die Verstärker (T1, T2) in die Lage versetzt werden, die zu verstärkenden Signale zu verstärken.

7. Anordnung nach einem der Ansprüche 3 bis 6,
**dadurch gekennzeichnet,**
**daß** dann, wenn die sich am Eingangsanschluß (G1) des ersten Verstärkers (T1) einstellende Gleichspannung einen Wert hat, bei welchem die durch den ersten Verstärker (T1) zu verstärkenden Signale verstärkt werden können, die sich am Eingangsanschluß (G1) des zweiten Verstärkers (T2) einstellende Gleichspannung auf einem Wert gelassen oder gebracht wird, bei welchem der zweite Verstärker (T2) nicht in der Lage ist, die zu verstärkenden Signale zu verstärken.

8. Anordnung nach einem der Ansprüche 3 bis 7,
**dadurch gekennzeichnet,**
**daß** dann, wenn die sich am Eingangsanschluß (G1) des ersten Verstärkers (T1) einstellende Gleichspannung einen Wert hat, bei welchem der erste Verstärker (T1) nicht in der Lage ist, die zu verstärkenden Signale zu verstärken, die sich am Eingangsanschluß (G1) des zweiten Verstärkers (T2) einstellende Gleichspannung auf einem Wert gelassen oder gebracht wird, bei welchem der zweite Verstärker (T2) in der Lage ist, die zu verstärkenden Signale zu verstärken.

9. Anordnung nach einem der Ansprüche 3 bis 8,
**dadurch gekennzeichnet,**
**daß** die sich am Eingangsanschluß (G1) des ersten Verstärkers (T1) einstellende Gleichspannung über den Anschluß (E1), über welchen der Anordnung die durch den ersten Verstärker (T1) zu verstärkenden Signale zugeführt werden, einstellbar oder veränderbar ist.

10. Anordnung nach einem der vorhergehenden Ansprüche,
**dadurch gekennzeichnet,**
**daß** der erste und der zweite Verstärker (T1 T2) ein erster und ein zweiter Transistor sind, und daß die Verhältnisse, abhängig von welchen der zweite Transistor betrieben wird, die Höhe oder der Verlauf der sich am Gateanschluß des ersten Transistors einstellenden Spannung sind.

11. Anordnung nach einem der Ansprüche 1 bis 10,
**dadurch gekennzeichnet, daß**
die ersten und zweiten Verstärker (T1, T2) jeweils als Transistoren mit zwei Gateanschlüssen (G1, G2) ausgebildet sind, von denen der erste Gateanschluß (G1) den Anschluß für das zu verstärkende Signal und der zweite Gateanschluß (G2) den Anschluß für die Einstellung der Verstärkung bildet, daß jedem der Verstärker (T1, T2) ein weiterer Transistor (H1, H2) zugeordnet ist mit einer gesteuerten Strecke und je zwei Gateanschlüssen, daß die Gateanschlüsse der Verstärker (T1, T2) mit den Gateanschlüssen der zugeordneten weiteren Transistoren (H1, H2) jeweils gekoppelt sind, daß die gesteuerten Strecken der weiteren Transistoren (H1, H2) einerseits an den Anschluß für das Massepotential (0) angeschlossen sind und andererseits an die gesteuerte Strecke des zugeordneten Verstärkers (T1, T2) gekoppelt sind.

12. Anordnung nach Anspruch 11,
**dadurch gekennzeichnet, daß**
die Anschlüsse (G1) für ein zu verstärkendes Signal der Verstärker (T1, T2) mit den Gateanschlüssen der weiteren Transistoren (H1, H2) jeweils über die Reihenschaltung zweier Widerstände (R_{E1a}, R_{E1b}, R_{E2a}, R_{E2b}) gekoppelt sind und daß die Drain-Source Strecke des Schalttransistors (S1) sowie der Gate-Anschluß des Schalttransistors (S1) jeweils an einen der Knoten zwischen den Widerständen (R_{E1a}, R_{E1b}, R_{E2a}, R_{E2b}) jeweils einer der Reihenschaltungen gekoppelt sind.

## Claims

1. Arrangement with a first amplifier (T1) having a terminal for a signal to be amplified (G1, E1) and a controlled path (D, S), with a second amplifier (T2) having a terminal for a signal to be amplified (G1, E2) and a controlled path (D, S), where the controlled paths are connected to a terminal (0) for a ground potential,
**characterized by**
a switching transistor (S1) whose drain-source path, on the one hand, is connected at its drain terminal to one of the terminals for the signal to be amplified (G1, E2) of one of the amplifiers (T2) and, on the other hand, is connected at its source terminal to the terminal (0) for the ground potential, where a gate terminal controlling the drain-source path of the switching transistor (S1) is connected to the terminal for the signal to be amplified (G1, E1) of the other amplifier (T1).

2. Arrangement according to claim 1, **characterized in that** the conditions, depending on which the second amplifier (T2) is operated, are the level or the profile of the voltage establishing at the input terminal (G1) of the first amplifier (T1).

3. Arrangement according to claim 1 or 2, **characterized in that** the signals to be amplified by the amplifiers (T1, T2) are analog AC voltages, and that the conditions, depending on which the second amplifier (T2) is operated, is the level of the DC voltage establishing at the input terminal (G1) of the first amplifier (T1).

4. Arrangement according to claim 3, **characterized in that** the DC voltage establishing at the input terminal (G1) of the second amplifier (T2) is varied depending on the DC voltage establishing at the input terminal (G1) of the first amplifier (T1).

5. Arrangement according to any one of the preceding claims, **characterized in that** DC voltages are generated within the arrangement and applied to the input terminals (G1) of the amplifiers (T1, T2).

6. Arrangement according to claim 5, **characterized in that** the internally generated DC voltages applied to the input terminals (G1) of the amplifiers (T1, T2) have a value by which the amplifiers (T1, T2) are enabled to amplify the signals to be amplified.

7. Arrangement according to any one of the claims 3 to 6, **characterized in that** the DC voltage establishing at the input terminal (G1) of the second amplifier (T2) is left at or brought to a value at which the second amplifier (T2) is unable to amplify the signals to be amplified, if the DC voltage establishing at the input terminal (G1) of the first amplifier (T1) has a value at which the signals to be amplified by the first amplifier (T1) can be amplified.

8. Arrangement according to any one of the claims 3 to 7, **characterized in that** the DC voltage establishing at the input terminal (G1) of the second amplifier (T2) is left at or brought to a value at which the second amplifier (T2) is able to amplify the signals to be amplified, if the DC voltage establishing at the input terminal (G1) of the first amplifier (T1) has a value at which the first amplifier (T1) is unable to amplify the signals to be amplified.

9. Arrangement according to any one of the claims 3 to 8, **characterized in that** the DC voltage establishing at the input terminal (G1) of the first amplifier (T1) is adjustable or variable via the terminal (E1) via which the signals to be amplified by the first amplifier (T1) are supplied to the arrangement.

10. Arrangement according to any one of the preceding claims, **characterized in that** the first and the second amplifier (T1, T2) are a first and a second transistor, and that the conditions, depending on which the second transistor is operated, are the level or the profile of the voltage establishing at the gate terminal of the first transistor.

11. Arrangement according to any one of the claims 1 to 10, **characterized in that** the first and second amplifiers (T1, T2) each are designed as transistors with two gate terminals (G1, G2), of which the first gate terminal (G1) forms the terminal for the signal to be amplified and the second gate terminal (G2) forms the terminal for setting the gain, that a further transistor (H1, H2) having a controlled path and two gate terminals each is assigned to each of the amplifiers (T1, T2), that the gate terminals of the amplifiers (T1, T2) are coupled to the gate terminals of the assigned further transistors (H1, H2), respectively, that the controlled paths of the further transistors (H1, H2), on the one hand, are connected to the terminal for the ground potential (0) and, on the other hand, are coupled to the controlled path of the assigned amplifier (T1, T2).

12. Arrangement according to claim 11, **characterized in that** the terminals (G1) for a signal to be amplified of the amplifiers (T1, T2) are coupled to the gate terminals of the further transistors (H1, H2) via the series connection of two resistors (R_{E1a}, R_{E1b}, R_{E2a}, R_{E2b}), respectively, and that the drain-source path of the switching transistor (S1) as well as the gate terminal of the switching transistor (S1) are coupled to one of the nodes between the resistors (R_{E1a}, R_{E1b}, R_{E2a}, R_{E2b}) of a respective one of the series connections, respectively.

## Revendications

1. Dispositif comprenant un premier amplificateur (T1) qui a une borne pour un signal (G1, E1) à amplifier et une section (D, S) commandée, un deuxième amplificateur (T2) qui a une borne pour un signal (G1, E2) à amplifier et une section (D, S) commandée, les sections commandées étant reliées à une borne (0) pour un potentiel de masse,
**caractérisé par**
un transistor (S1) de commutation dont la section de drain-source est reliée, d'une part, à sa borne de drain sur l'une des bornes pour le signal (G1, E2) à amplifier de l'un des amplificateurs (T2) et, d'autre part, à sa borne de source sur la borne (0) pour le potentiel de masse, une borne de grille, commandant la section de drain-source du transistor (S1) de commutation, étant reliée à la borne pour le signal (G1, E1) à amplifier de l'autre amplificateur (T1).

2. Dispositif suivant la revendication 1,
**caractérisé**
**en ce que** les conditions en fonction desquelles fonctionne le deuxième amplificateur (D2) sont le niveau ou la courbe de la tension s'établissant à la borne (G1) d'entrée du premier amplificateur (T1).

3. Dispositif suivant la revendication 1 ou 2,
**caractérisé**
**en ce que** les signaux à amplifier par les amplificateurs (T1, T2) sont des tensions alternatives analogiques et en ce que les conditions en fonction desquelles le deuxième amplificateur (T2) fonctionne sont le niveau de la tension continue s'établissant à la borne (G1) d'entrée du premier amplificateur (T1).

4. Dispositif suivant la revendication 3,
**caractérisé en ce qu'**en fonction de la tension continue s'établissant à la borne (G1) d'entrée du premier amplificateur (T1), on fait varier la tension continue s'établissant à la borne (G1) d'entrée du deuxième amplificateur (T2).

5. Dispositif suivant l'une des revendications précédentes,
**caractérisé en ce qu'**on produit dans le dispositif des tensions continues et on les applique aux bornes (G1) d'entrée des amplificateurs (T1, T2).

6. Dispositif suivant la revendication 5,
**caractérisé en ce que** les tensions continues produites de façon interne et appliquées aux bornes (G1) d'entrée des amplificateurs (T1, T2) ont une valeur par laquelle les amplificateurs (T1, T2) sont mis en mesure d'amplifier les signaux à amplifier.

7. Dispositif suivant l'une des revendications 3 à 6,
**caractérisé en ce que** la tension continue s'établissant à la borne (G1) d'entrée du premier amplificateur (T1) a une valeur pour laquelle les signaux à amplifier par le premier amplificateur (T1) peuvent être amplifiés, la tension continue s'établissant à la borne (G1) d'entrée du deuxième amplificateur (T2) peut être laissée ou mise à une valeur pour laquelle le deuxième amplificateur (T2) n'est pas en mesure d'amplifier les signaux à amplifier.

8. Dispositif suivant l'une des revendications 3 à 7,
**caractérisé**
Lorsque la tension continue s'établissant à la borne (G1) d'entrée du premier amplificateur (T1) a une valeur pour laquelle le premier amplificateur (T1) n'est pas en mesure d'amplifier les signaux à amplifier, la tension continue s'établissant à la borne (G1) d'entrée du deuxième amplificateur (T2) est laissée ou est mise à une valeur pour laquelle le deuxième amplificateur est en mesure d'amplifier les signaux à amplifier.

9. Dispositif suivant l'une des revendications 3 à 8,
**Caractérisé en ce que** la tension continue s'établissant à la borne (G1) d'entrée du premier amplificateur (T1) peut être réglée ou modifiée par la borne (E1) par laquelle les signaux à amplifier par le premier amplificateur (T1) sont envoyés au dispositif.

10. Dispositif suivant l'une des revendications précédentes,
**caractérisé en ce que** le premier et le deuxième amplificateurs (T1, T2) sont un premier et un deuxième transistors et **en ce que** les conditions en fonction desquelles le deuxième transistor fonctionne sont le niveau ou la courbe de la tension s'établissant à la borne de grille du premier transistor.

11. Dispositif suivant l'une des revendications 1 à 10,
**caractérisé en ce que** le premier et le deuxième transistors (T1, T2) sont respectivement constitués sous la forme de transistor ayant deux bornes (G1, G2) de grille, dont la première borne (G1) de grille forme la borne pour le signal à amplifier et la deuxième borne (G2) de grille forme la borne pour l'établissement de l'amplification, **en ce que** chacun des amplificateurs (T1, T2) est associé à un autre transistor (H1, H2) ayant une section commandée et respectivement deux bornes de grille, **en ce que** les bornes de grille des amplificateurs (T1, T2) sont couplées respectivement aux bornes de grille des autres transistors (H1, H2) associés, **en ce que** les sections commandées des autres transistors (H1, H2) sont reliées, d'une part, à la borne pour le potentiel (0) de masse et sont couplées, d'autre part, à la section commandée de l'amplificateur (T1, T2) associé.

12. Dispositif suivant la revendication 11,
**caractérisé en ce que** les bornes (G1) pour un signal à amplifier des amplificateurs (T1, T2) sont couplées aux bornes de grille des autres transistors (H1, H2) respectivement par le circuit série de deux résistances (R_{E1a}, R_{E1b}, R_{E2a}, R_{E2b}) et **en ce que** la section de drain-source du transistor (S1) de commutation ainsi que la borne de grille du transistor (S1) de commutation sont couplées respectivement à l'un des noeuds entre les résistances (R_{E1a}, R_{E1b}, R_{E2a}, R_{E2b}) respectivement de l'un des circuits série.
